# EUROPEAN PATENT SPECIFICATION

(11) **EP 1 660 606 B1**
(45) Date of publication and mention of the grant of the patent: **04.09.2013**
(21) Application number: 04777834.5
(22) Date of filing: 09.07.2004
(51) Int. Cl.: C09K 3/14, C09G 1/02, H01L 21/321

(54) **ABRASIVE PARTICLES FOR CHEMICAL MECHANICAL POLISHING**
ABRASIVE TEILCHEN ZUM CHEMISCH-MECHANISCHEN POLIEREN
PARTICULES ABRASIVES POUR POLISSAGE MECANICO-CHIMIQUE

(30) Priority: 11.07.2003 US 486686 P
(43) Date of publication of application: 31.05.2006
(73) Proprietor: W.R. Grace & CO. - CONN., Colombia, MD 21044-4098 (US)
(72) Inventor: CHU, Jia-Ni, Wilmington, Delaware 19803 (US); PRYOR, James Neil, West Friendship, Maryland 21794 (US)
(74) Representative: UEXKÜLL & STOLBERG
(86) International application number: PCT/US2004/021998
(87) International publication number: WO 2005/007770

(56) References cited:
- WO-A-01/74959
- WO-A-01/85868
- WO-A-01/98201
- US-A1- 2001 017 007
- US-A1- 2002 028 636
- US-A1- 2003 124 850
- US-B1- 6 527 817

## Description

### BACKGROUND OF THE INVENTION

The present invention relates to abrasive particles and slurries containing the particles, as well as chemical mechanical planarization (CMP) processes utilizing the slurries.

Slurries containing abrasive and/or chemically reactive particles in a liquid median are utilized for a variety of polishing and planarizing applications. Some applications include polishing technical glass, mechanic memory disks, native silicon wafers and stainless steel used in medical devices. CMP is utilized to flatten and smooth a substrate to a very high degree of uniformity. CMP is used in a variety of applications, including polishing of glass products, such as flat panel display glass faceplates, and planarization of wafer devices during semiconductor manufacture. For example, the semiconductor industry utilizes CMP to planarize dielectric and metal films, as well as patterned metal layers in various stages of integrated circuit manufacture. During fabrication, the surface of the wafer is typically subdivided into a plurality of areas (typically rectangular) onto which are formed photolithographic images, generally identical circuit patterns from area to area. Each of the rectangular areas eventually becomes an individual die once the wafer is diced into individual pieces.

The integrated circuit die, especially in very large scale integrated (VLSI) semiconductor circuits, are manufactured by depositing and patterning both conductive layer (or layers) and nonconductive (insulating) layer or layers upon a semiconductor wafer. Present technology typically makes use of a silicon dioxide insulator, although other materials are becoming increasingly common. The layers are formed in a layered, laminate configuration, stacked upon one another, creating a non-planner topography. One source of non-planarity is caused by non-conductive or dielectric layers being formed over raised conductive lines or other features in the underlying layers, causing topographic structure in the overlying layers. Planarization is needed for accurate deposition and patterning of subsequent layers.

Another source of non-planarity is caused by the copper damascene process and with the increasing need for planar or smooth hard disks. In the copper damascene process (1) trenches are etched into a dielectric layer, (2) a barrier layer is deposited thinly lining the trench and thinly covering the inter-trench dielectric, (3) copper is deposited at a thickness to fill the trench while also coating the inter-trench regions, and (4) a CMP process is used to polish away the copper in the inter-trench regions while leaving as much copper as possible within the trench.

As integrated circuit devices have become more sophisticated and more complex, the number of layers that act upon one another is increased. As the number of layers increase, the planarity problems generally increase as well. Planarizing the layers during the processing of integrated circuits has become a major problem and a major expense in producing semiconductor devices. The planarity requirements have resulted in a number of approaches, and most recently, CMP techniques have been utilized to planarize the semiconductor wafers. CMP consists of moving a non-planarized unpolished surface against a polishing pad with a CMP slurry disposed between the pad and the surface being treated. This is typically accomplished by continuously coating the pad with a slurry and spinning the pad against the substrate at relatively low speeds. The CMP slurry includes at least one or two components; abrasive particles for mechanical removal of substrate material and one or more reactants for chemical removal of substrate material. The reactants are typically simple complexing agents or oxidizers, depending on the materials to be polished, and acids or bases to tailor the pH.

CMP slurries can be placed into categories based on the materials to be polished. Oxide polishing refers to the polishing of the outside or interlayer dielectric in integrated circuits, while metal polishing is the polishing of metal interconnects (plugs) in integrated circuits. Silica and alumina are most widely used as abrasives for metal polishing, while silica is used almost exclusively for oxide polishing. Ceria is also used for some applications, including metal polishing and polymer polishing.

A range of parameters which characterize the action of the polishing slurry represent an assessment scale for the efficiency of the polishing slurries. These parameters include; the abrasion rate, i.e., the rate at which the material to be polished is removed, the selectivity, i.e., the ratio of the polish rates of material that is to be polished to other materials which are present on the surface of the substrate, and parameters that represent the uniformity of planarization. Parameters used to represent the uniformity of planarization are usually within-wafer non-uniformity (WIWNU) and the wafer-to-wafer non-uniformity (WTWNU), as well as the number of defects per unit area.

In various prior CMP slurries the raw material for producing the polishing slurries has been oxide particles, such as silicas, that comprise large aggregates of smaller primary particles, i.e., small generally spherical primary particles are securely bonded together to form larger; irregularly shaped particles. Thus, to produce polishing slurries it is necessary for these aggregates to be broken down into particles that are as small as possible. This is achieved by the introduction of sheering energy. The sheering energy causes the aggregates of silica to be broken down. However, since the efficiency of introduction of the sheering energy is dependent on the particle size, it is not possible to produce particles of the size and shape of the primary particles using the sheering force. The polishing slurries produced in this way have a drawback that aggregates are not fully broken down. This coarse particle fraction may lead to the increased formation of scratches or defects on the surface of the substrate that is to be polished.

Some work has been directed to the tailoring of the abrasive particle component. For example, U.S. Patent No. 5,264,010 describes an abrasive composition for use in planarizing the surface of a substrate, wherein the abrasive component includes 3 to 50 wt. % cerium oxide, 8 to 20 wt. % fumed silica, and 15 to 45 wt. % precipitated silica. U.S. Patent No. 5,527,423 discloses a slurry for use in chemical mechanical polishing of metal layers. The slurry includes abrasive particles that are agglomerates of very small particles and are formed from fumed silicas or fumed aluminas. The agglomerated particles, typical of fumed materials, have a jagged, irregular shape. The particles possess an aggregate size distribution with almost all particles less than about 1 micron, and a mean aggregate diameter of less than about 0.4 microns.

U.S. Patent No. 5,693,239 describes a CMP slurry which includes abrasive particles wherein about 15 wt. % of the particles are crystalline alumina and the remainder of the particles are less abrasive materials such as alumina hydroxides, silica and the like.

U.S. Patent No. 5,376,222 discloses the use of basic silica sols containing spherical particles having a pH of between 9 and 2.5. Such polishing slurries have the advantage that they are practically only comprised of discrete spherical particles, which lead to low levels of scratches and other defects on the surface that is to be polished.

The drawback of these polishing slurries is their lower polish rate while minimizing the defect rate.

Efforts to increase the polish rate while minimizing defects have focused on particle size distribution of the abrasive component. U.S. Patent No. 6,143,662, U.S. Patent Application Publication Nos. 2002/0003225 A1 and 2003/0061766 A1 describe CMP slurries containing abrasive particles having a very narrow particle size distribution and that are bi-modal or multi-modal in nature. Even though the slurries demonstrate a higher polish rate, such slurries suffer from the occurrence of higher defect densities. WO 01/85868 discloses polydisperse silica and its use in chemical-mechanical polishing.

Accordingly, there continues to be a need for polishing slurries with improved properties. In particular, polishing slurries that provide a sufficiently high polish rate, increased substrate surface smoothness, good planarization and low defect densities are needed for today's VLSI manufacturing.

### SUMMARY OF THE INVENTION

The present invention relates to an abrasive composition for polishing substrates including a plurality of abrasive particles having a polydisperse particle size distribution with median particle size, by volume, being about 20 nanometers to about 100 nanometers, the span value, by volume, being greater than or equal to about 20 nanometers, wherein the fraction of particles greater than about 100 nanometers is less than or equal to about 20% by volume of the abrasive particles.

The present invention also relates to an abrasive slurry composition for polishing substrates including a plurality of abrasive particles having a Polydisperse particle size distribution with median particle size, by volume, being about 20 nanometers to about 100 nanometers a span value, by volume, being greater than or equal to about 20 nanometers, wherein the fraction of particles greater than or equal to about 100 nanometers is less than or equal to about 20% by volume of the abrasive particles; and a solution having one or more chemical reactants.

The present invention also regards a method for polishing substrates with an abrasive composition by providing a substrate to be polished; and polishing the substrate using a plurality of abrasive particles having a polydisperse particle size distribution with median particle size, by volume, being about 20 nanometers to about 100 nanometers, a span value, by volume, being greater than or equal to about 20 nanometers, wherein the fraction of particles greater than or equal to about 100 nanometers is less than or equal to about 20% by volume of the abrasive particles.

### BRIEF DESCRIPTION OF DRAWINGS

FIG. 1 is a graphical representation of an example abrasive of the invention having a polydisperse particle size distribution (by volume).

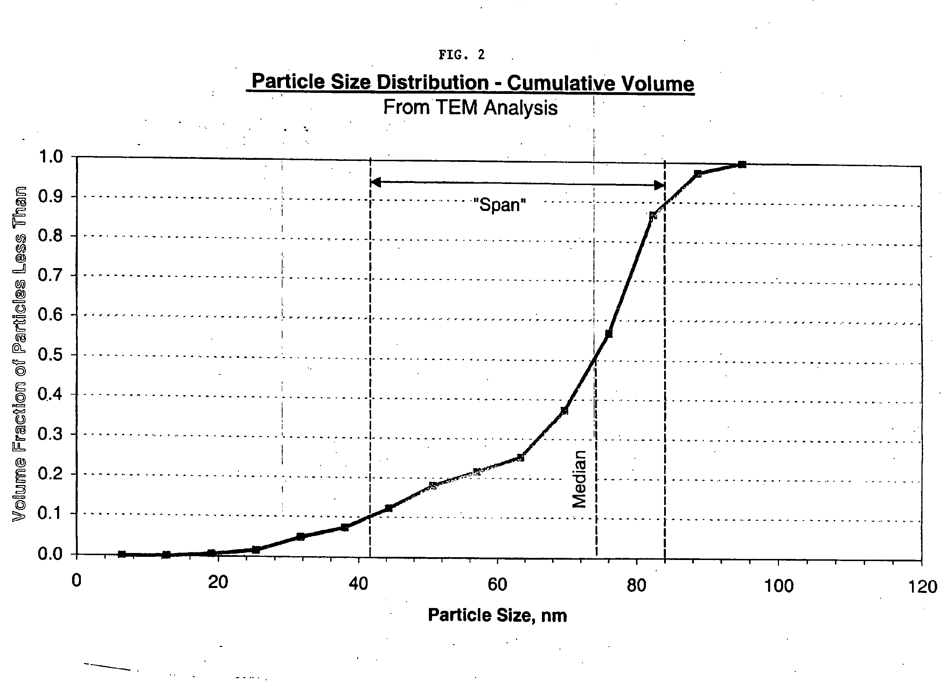

FIG. 2 is a graphical representation of the cumulative volume distribution of an example abrasive of the invention having a polydisperse particle size distribution.

### DETAILED DESCRIPTION OF THE INVENTION.

The term "abrasive" as used herein means any synthetic and/or natural inorganic and organic material, which are relatively inert when utilized in CMP slurries, such as, for example, fumed, colloidal and precipitated silica, alumina, aluminum silicate, cerium oxide, titanium dioxide, zirconium oxide, and the like; clays, such as mica, bentonite, smectite, laponite, and the like; polymers, such as polystyrene, polymethyl methacrylate, and the like; and any combination and/or mixtures thereof.

In an embodiment of the present invention colloidal silica is utilized as the abrasive. By the term "colloidal silica" or "colloidal silica sol" it is meant particles originating from dispersions or sols in which the particles do not settle from dispersion over relatively long periods of time. Such particles are typically below one micron in size. Colloidal silica having an average particle size in the range of about 1 to about 300 nanometers and processes for making the same are well known in the art. See U.S. Patents 2,244,325; 2,574,902; 2,577,484; 2,577,485; 2,631,134; 2,750,345; 2,892,797; 3,012,972; and 3,440,174.

Silica sols may be obtained by condensation of dilute silicic acid solutions which have been freshly prepared from molecular silicate solutions, more rarely by peptization of silica gels or by other processes. Most of the processes for preparing silica sols that are carried out on at industrial scale use technical-grade sodium or potassium silicate solutions made from water glass. Sodium silicates are preferred for cost reasons and sodium silicates with a weight ratio of silica to soda of about 3.2 to 3.34:1 are most preferred. Soda water glasses or potash water glasses are suitable raw materials used in the manufacture of sodium silicate or potassium silicate solutions. The water glasses are usually prepared by high temperature fusion of silica and soda or potash. The sodium silicate or potassium silicate solution is prepared by dissolving a comminuted form of the glass into water at elevated temperatures and/or pressures. Other processes to make sodium silicates are known and include the reaction of finely divided quartz or other suitable silica raw materials with alkali under hydrothermal conditions.

Preparation of silica sols used in the polishing abrasives, as taught by the patents herein referenced, involves removal of some or most of the metal cations present in a dilute sodium silicate solution, usually by a cation exchange material in the hydrogen form. In many disclosed processes, the dilute sodium silicate is passed through a bed of cation exchange resin to remove the sodium and the resulting "silicic acid" is added to a vessel either containing a "heel" of enough alkali to maintain the solution at neutral to alkaline pH or a "heel" of an alkaline sol of previously prepared colloidal silica particles. A different process is also disclosed that involves the simultaneous addition of dilute sodium silicate and ion exchange resin to a "heel" of water, dilute sodium silicate, or an alkaline sol of previously prepared colloidal silica particles, such that the pH is maintained at a constant, alkaline value. Any of these methods may be used to make colloidal silica sols of this invention. By varying conditions of addition rates, pH, temperature and the nature of the "heel," particles can be grown encompassing the range between about 1 to about 300 nm in diameter and have specific surface areas of about 9 to about 3000 m²/g (as measured by BET) in sols that have SiO₂:Na₂O ratios of about 40:1 to about 300:1. The resulting sols may be further concentrated by means of ultrafiltration, distillation, vacuum distillation or other similar means. Although they may be stable at pH of about 1 to about 7 for relatively short periods of time, they are indefinitely stable in alkaline pH, especially from about pH 8 to about pH 11. Below about pH 8, the colloidal silica particles will tend to aggregate and form gels. Above about pH 11 and certainly above pH 12, the particles will tend to dissolve.

It is also possible to prepare the silica sols used by further processes. For example, this preparation is possible by hydrolysis of tetraethyl orthosilicate (TEOS). Silica sols made by these processes are typically very costly and therefore have found limited use.

Most colloidal silica sols contain an alkali. The alkali is usually an alkali metal hydroxide from Group IA of the Periodic Table (hydroxides of lithium, sodium, potassium, etc.) Most commercially available colloidal silica sols contain sodium hydroxide, which originates, at least partially, from the sodium silicate used to make the colloidal silica, although sodium hydroxide may also be added to stabilize the sol against gellation. They may also be stabilized with other alkaline compounds, such as ammonium hydroxide or organic amines of various types. If the presence of sodium or other alkali metal ion is deleterious to the polishing application, the colloidal silica sol may be deionized with cation exchange resin in the hydrogen form and then re-stabilized with the desired alkaline compound.

Alkaline compounds stabilize colloidal silica particles by reaction with the silanol groups present on the surface of the colloidal silica particles. The result of this reaction is that the colloidal silica particles possess a negative charge that creates a repulsive barrier to interparticle aggregation and gelling. Alternatively, the colloidal silica surface may be modified stabilize the particle. One method, disclosed in US Patent 2,892,797, forms an aluminosilicate anion on the particle surface and imparts a negative charge on the colloidal silica particle. In still another method, as disclosed by US Patents 3,007,878, 3,620,978 and 3,745,126 the colloidal silica particles may be positively charged by coating the particle with a polyvalent metal oxide. Suitable polyvalent oxides include the tri- and tetravalent metals of aluminum, zirconium, titanium, gallium, and chromium but aluminum is preferred.

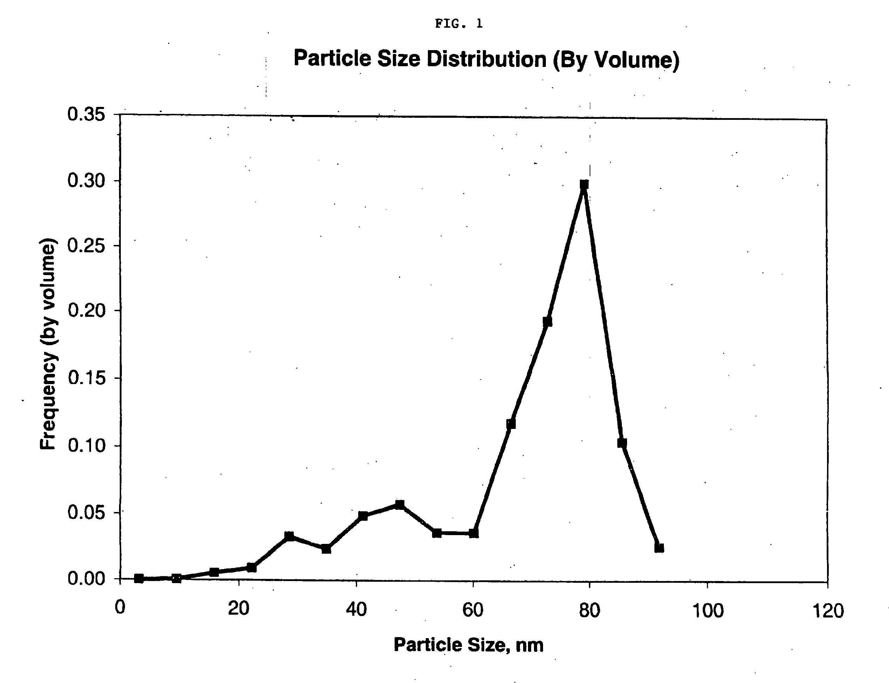

A colloidal silica particularly suitable for this invention is what is known as polydisperse colloidal silica. "Polydisperse" is defined herein as meaning a dispersion of particles having a particle size distribution in which the median particle size is in the range of 15-100 nm and which has a relatively broad distribution. "Span" is defined herein as meaning a measure of the breadth of particle size distribution. Suitable distributions are such that the median particle size, by volume, is about 20 nanometers to about 100 nanometers; the span value, by volume, is greater than or equal to about 15 nanometers; and the fraction of particles greater than 100 nanometers is less than or equal to about 20% by volume of the abrasive particles. The span (by volume) range is measured by subtracting the d₁₀ particle size (i.e., the size below which are 10% by volume of the particles) from the d₉₀ particle size (i.e., the size below which are 90% by volume of the particles) generated using transmission electron photomicrographs (TEM) particle size measurement methodologies. For example, TEM of abrasive particle samples were analyzed by conventional digital image analysis software to determine volume weighted median particle diameters and size distributions. As a result, the distribution has a relatively broad span and yet a very small number of particles that are relatively large (e.g., above 100 nanometers). See Figure 1. Such large particles contribute to scratching and the appearance of defects on the surface of the substrate subsequent_to the CMP process. Additionally, the presence of a significant quantity of large particles (e.g., greater than 100 nm) in the dispersion may result in settling during storage, yielding a non-uniform suspension and the possible formation of a cake of larger particles on the bottom surface of the storage container. Once such a cake forms, it is difficult to completely re-disperse the settled particles, and any resuspension may contain aggregates of the particles. Moreover, use of storage containers comprising non-uniform particle distributions or suspensions, or use of suspensions including aggregates of large particles, may not consistently provide the advantageous polishing benefits of the present invention.

Preferred particle distributions are those where the abrasive particles include median particle size, by volume, of about 20, 25, 30 or 35 nanometers to about 100, 95, 90 or 85 nanometers; a span value, by volume, of greater than or equal to about 15, 18, 20, 22, 25 or 30 nanometers; and a fraction of particles greater than about 100 nanometers of less than or equal to 20, 15, 10, 5, 2, 1, or greater than 0 to 1% by volume of the abrasive particles. It is important to note that any of the amounts set forth herein with regard to the median particle size, span value, and fraction of particles above 100 nanometers may be utilized in any combination to make up the abrasive particles. For example, a suitable abrasive particle distribution includes a median particle size, by volume, of about 25 nanometers to about 95 nanometers, a span value, by volume, of greater than or equal to about 18 nanometers, and a fraction of particles greater than about 100 nanometers less than or equal to about 20% by volume of the abrasive particles. A preferred abrasive particle distribution includes a median particle size, by volume, of about 25 nanometers to about 100 nanometers, a span value, by volume, of greater than or equal to about 18 nanometers, and a fraction of particles greater than about 100 nanometers less than or equal to about 15% by volume of the abrasive particles. A more preferred abrasive particle distribution includes a median particle size, by volume, of about 25 nanometers to about 100 nanometers, a span value, by volume, of greater than or equal to about 25 nanometers, and a fraction of particles greater than about 100 nanometers less than or equal to about 10% by volume of the abrasive particles. An even more preferred abrasive particle distribution includes a median particle size, by volume, of about 25 nanometers to about 100 nanometers, a span value, by volume, of greater than or equal to about 30 nanometers, and a fraction of particles greater than about 100 nanometers less than or equal to about 5% by volume of the abrasive particles.

In another embodiment of the present invention also relates to an abrasive slurry composition for polishing substrates including a plurality of abrasive particles having a polydisperse particle size distribution as described herein in a solution having one or more chemical reactants.

The present CMP slurry can be used in conjunction with any suitable component (or ingredient) known in the art, for example, additional abrasives, oxidizing agents, catalysts, film-forming agents, complexing agents, rheological control agents, surfactants (i.e., surface-active agents), polymeric stabilizers, pH-adjusters, corrosion inhibitors and other appropriate ingredients.

Any suitable oxidizing agent can be used in conjunction with the present invention. Suitable oxidizing agents include, for example, oxidized halides (e.g., chlorates, bromates, iodates, perchlorates, perbromates, periodates, fluoride-containing compounds, and mixtures thereof, and the like). Suitable oxidizing agents also include, for example, perboric acid, perborates, percarbonates, nitrates (e.g., iron (III) nitrate, and hydroxylamine nitrate), persulfates (e.g., ammonium persulfate), peroxides, peroxyacids (e.g., peracetic acid, perbenzoic acid, m-chloroperbenzoic acid, salts thereof, mixtures thereof, and the like), permanganates, chromates, cerium compounds, ferricyanides (e.g., potassium ferricyanide), mixtures thereof, and the like. It is also suitable for the composition used in conjunction with the present invention to contain oxidizing agents as set forth, for example, in U.S. Patent No. 6,015,506, the entire subject matter of which is incorporated herein by reference.

Any suitable catalyst can be used in conjunction with the present invention. Suitable catalysts include metallic catalysts, and combinations thereof. The catalyst can be selected from metal compounds that have multiple oxidation states, such as but not limited to Ag, Co, Cr, Cu, Fe, Mo, Mn, Nb, Ni, Os, Pd, Ru, Sn, Ti, and V. The term "multiple oxidation states" refers to an atom and/or compound that has a valence number that is capable of being augmented as the result of a loss of one or more negative charges in the form of electrons. Iron catalysts include, but are not limited to, inorganic salts of iron, such as iron (II or III) nitrate, iron (II or III) sulfate, iron (II or III) halides, including fluorides, chlorides, bromides, and iodides, as well as perchlorates, perbromates, and periodates, and ferric organic iron (II or III) compounds such as but not limited to acetates, acetylacetonates, citrates, gluconates, oxalates, phthalates, and succinates, and mixtures thereof.

Any suitable film-forming agent (i.e., corrosion inhibitor) can be used in conjunction with the present invention. Suitable film-forming agents include, for example, heterocyclic organic compounds (e.g., organic compounds with one or more active functional groups, such as heterocyclic rings, particularly nitrogen-containing heterocyclic rings). Suitable film-forming agents include, for example, benzotriazole, triazole, benzimidazole, and mixtures thereof, as set forth in U.S. Publication No. 2001/0037821.

Any suitable complexing agent (i.e., chelating agent or selectivity enhancer) can be used in conjunction with the present invention. Suitable complexing agents include, for example, carbonyl compounds (e.g. acetylacetonates and the like), simple carboxylates (e.g., acetates, aryl carboxylates, and the like), carboxylates containing one or more hydroxyl groups (e.g., glycolates, lactates, gluconates, gallic acid and salts thereof, and the like), di-,tri-, and poly-carboxylates (e.g., oxalates, phthalates, citrates, succinates, tartrates, malates, edetates (e.g. disodium EDTA), mixtures thereof, and the like), carboxylates containing one or more sulfonic and/or phosphonic groups, and carboxylates as set forth in U.S. Patent Publication No. 2001/0037821 A1. Suitable chelating or complexing agents also can include, for example, di-, tri-, or polyalcohols (e.g., ethylene glycol, pyrocatechol, phyrogallol, tannic acid, and the like) and phosphate containing compounds, e.g. phosphonium salts, and phosphonic acids, as set forth, for example, in U.S. patent application Serial No. 09/405,249. Complexing agents can also include amine-containing compounds (e.g., amino acids, amino alcohols, di-, tri-, and poly-amines, and the like). Examples of amine-containing compounds include methylamine, dimethylamine, trimethylamine, ethylamine, diethylamine, triethylamine, ethanolamine, diethanolamine, diethanolamine dodecate, triethanolamine, isopropanolamine, diisopropanolamine, triisopropanolamine, nitrosodiethanolamine, and mixtures thereof. Suitable amine-containing compounds further include ammonium salts (e.g., TMAH and quaternary ammonium compounds). The amine-containing compound also can be any suitable cationic amine-containing compound, such as, for example, hydrogenerated amines and quaternary ammonium compounds, that adsorbs to the silicon nitride layer present on the substrate being polished and reduces, substantially reduces, or even inhibits (i.e., blocks) the removal of silicon nitride during polishing.

Any suitable surfactant and/or rheological control agent can be used in conjunction with the present invention, including viscosity enhancing agents and coagulants. Suitable rheological control agents include, for example, polymeric rheological control agents. Moreover, suitable rheological control agents include, for example, urethane polymers (e.g., urethane polymers with a molecular weight greater than about 100,000 Daltons), and acrylates comprising one or more acrylic subunits (e.g., vinyl acrylates and styrene acrylates), and polymers, copolymers, and oligomers thereof, and salts thereof. Suitable surfactants include, for example, cationic surfactants, anionic surfactants, anionic polyelectrolytes, nonionic surfactants, amphoteric surfactants, fluorinated surfactants, mixtures thereof, and the like.

The composition used in conjunction with the present invention can contain any suitable polymeric stabilizer or other surface active dispersing agent, as set forth in U.S. Publication No. 2001/0037821 A1. Suitable polymeric stabilizers include, for example, phosphoric acid, organic acids, tin oxides, organic phosphonates, mixtures thereof, and the like.

It will be appreciated that many of the aforementioned compounds can exist in the form of a salt (e.g., a metal salt, an ammonium salt, or the like), an acid, or as a partial salt. For example, citrates include citric acid, as well as mono-, di-, and tri-salts thereof; phthalates include phthalic acid, as well as mono-salts (e.g., potassium hydrogen phthalate) and di-salts thereof; perchlorates include the corresponding acid (i.e., perchloric acid), as well as salts thereof. Furthermore, the compounds recited herein have been classified for illustrative purposes; there is no intent to limit the uses of these compounds. As those skilled in art will recognize, certain compounds may perform more than one function. For example, some compounds can function both as a chelating and an oxidizing agent (e.g., certain ferric nitrates and the like).

Any of the components used in conjunction with the present invention can be provided in the form of a mixture or solution in an appropriate carrier liquid or solvent (e.g., water or an appropriate organic solvent). Furthermore, as mentioned, the compounds, alone or in any combination, can be used as a component of a polishing or cleaning composition. Two or more components then are individually stored and substantially mixed to form a polishing or cleaning composition at, or immediately before reaching, the point-of-use. A component can have any pH appropriate in view of the storage and contemplated end-use, as will be appreciated by those of skill in the art. Moreover, the pH of the component used in conjunction with the present invention can be adjusted in any suitable manner, e.g., by adding a pH adjuster, regulator, or buffer. Suitable pH adjusters, regulators, or buffers include acids, such as, for example, hydrochloric acid, acids such as mineral acids (e.g., nitric acid, sulfuric acid, phosphoric acid), and organic acids (e.g., acetic acid, citric acid, malonic acid, succinic acid, tartaric acid, and oxalic acid). Suitable pH adjusters, regulators, or buffers also include bases, such as, for example, inorganic hydroxide, bases (e.g., sodium hydroxide, potassium hydroxide, ammonium hydroxide, and the like) and carbonate bases (e.g., sodium carbonate and the like).

The polishing and cleaning components described herein can be combined in any manner and proportion to provide one or more compositions suitable for polishing or cleaning a substrate (e.g., a semiconductor substrate). Suitable polishing compositions are set forth, for example, in U.S. Patent Nos. 5,116,535, 5,246,624, 5,340,370, 5,476,606, 5,527,423, 5,575,885, 5,614,444, 5,759,917, 5,767,016, 5,783,489, 5,800,577, 5,827,781, 5,858,813, 5,868,604, 5,897,375, 5,904,159, 5,954,997, 5,958,288, 5,980,775, 5,993,686, 6,015,506, 6,019,806, 6,033,596 and 6,039,891 as well as in WO 97/43087, WO 97/47030, WO 98/13536, WO 98/23697, and WO 98/26025. Suitable cleaning compositions are set forth, for example, in U.S. Patent No. 5,837,662. The entire subject matter of these patents and publications are incorporated herein by reference.

In an embodiment of the present invention also regards a method for polishing substrates with an abrasive composition providing a substrate to be polished; and polishing the substrate using a plurality of abrasive particles having a polydisperse particle size distribution with median particle size, by volume, being about 30 nanometers to about 90 nanometers a span value, by volume, being greater than or equal to about 20 nanometers.

The present CMP slurry may be used to polish and planarize with any suitable substrate. The substrate may include any of the following materials as a single layer (e.g., in hard disk polishing) or as multiple layers in any configuration, such as, for example, is found in IC or VLSI manufacturing (e.g., including where multiple layers and/or materials are exposed and polished simultaneously, such as copper damascene processing). The substrates to be planarized may include conductive, superconductive, semiconductive, and insulative (e.g., high dielectric constant (k), regular k, low k, and ultra-low k) materials. Suitable substrates comprise, for example, a metal, a metal oxide, metal composite, or mixtures or alloys thereof. The substrate may be comprised of any suitable metal. Suitable metals include, for example, copper, aluminum, titanium, tungsten, tantalum, gold, platinum, iridium, ruthenium, and combinations (e.g., alloys or mixtures) thereof. The substrate also may be comprised of any suitable metal oxide. Suitable metal oxides include, for example, alumina, silica, titania, ceria, zirconia, germanic, magnesia, and conformed products thereof, and mixtures thereof. In addition, the substrate may include any suitable metal composition and/or metal alloy. Suitable metal composites and metal alloys include, for example, metal nitrides (e.g., tantalum nitride, titanium nitride, and tungsten nitride), metal carbides (e.g., silicon carbide and tungsten carbide), metal phosphides, metal silicides, metal phosphorus (e.g., nickel-phosphorus), and the like. The substrate also may include any suitable semiconductor base material, such as, for example, Group IV, Group II-VI and Group III-V materials. For example, suitable semiconductor base materials include single crystalline, poly-crystalline, amorphous, silicon, silicon-on-insulator, carbon, germanium, and gallium arsenide, cadmium telluride, silicon/germanium alloys, and silicon/germanium carbon alloys. Glass substrates can also be used in conjunction with the present invention including technical glass, optical glass, and ceramics, of various types known in the art (e.g., alumino-borosilicate, borosilicate glass, fluorinated silicate glass (FSG), phosphosilicate glass (PSG), borophosilicate glass (BPSG), etc.). The substrates may also comprise polymeric materials. The substrates and/or materials thereof may include dopants that change the conductivity of the material, such as, for example, boron or phosphorus doped silicon, etc. Suitable low k and ultra-low k materials include, for example, doped silicon dioxide films (e.g., fluorine or carbon doped silicon dioxide), glasses (e.g., FSG, PSG, BPSG, etc.), quartz (e.g., HSSQ, MSSQ, etc.), carbon (e.g., diamond-like carbon, fluorinated diamond-like carbon, etc.), polymers (e.g., polyimides, fluorinated polyimides, parylene N, benzocyclobutenes, aromatic thermoset/PAE, parylene-F fluoropolymers, etc.), porous materials (e.g., aerogels, xerogels, mesoporous silica, porous HSSQ/MSSQ, porous organics, etc.), and the like.

For example, the present invention can be used in conjunction with memory or rigid disks, metals (e.g., noble metals), barrier layers, ILD layers, integrated circuits, semiconductor devices, semiconductor wafers, micro-electromechanical systems, ferroelectrics, magnetic heads, or any other electronic device. The present method is especially useful in polishing or planarizing a semiconductor device, for example, semiconductor devices having device feature geometrics of about 0.25 µm or smaller (e.g., 0.18 µm or smaller). The term "device feature" as used herein refers to a single-function component, such as a transistor, resistor, capacitor, integrated circuit, or the like. A device features of the semiconductor substrate become increasingly small, the degree of planarization becomes more critical. A surface of semiconductor device is considered to be sufficiently planar when the dimensions of the smallest device features (e.g., device features of 0.25 µm or smaller, such as device features of 0.18 µm or smaller) can be resolved upon the surface via photolithography. The planarity of the substrate surface also can be expressed as a measure of the distance between the topographically highest and lowest points on the surface. In the context of semiconductor substrates, the distance between the topographically highest and lowest points on the surface. In the context of semiconductor substrates, the distance between the high and low points on the surface desirably is less than about 2000 Å, preferably less than about 1500 Å, more preferably less than about 500 Å, and most preferably less than about 100 Å

The present invention can be used to polish any part of a substrate (e.g., a semiconductor device) at any stage in the production of the substrate. For example, the present invention can be used to polish a semiconductor device in conjunction with shallow trench isolation (STI) processing, as set forth, for example, in U.S. Patent Nos. 5,498,565, 5,721,173, 5,938,505, and 6,019,806 or in conjunction with the formation of an interlayer dielectric.

In a typical CMP process, a slurry containing the abrasive particle dispersion of the present invention is utilized in conjunction with the one or more of the additives set forth herein. The amount of abrasive particle in the slurry may range from about 0.001 to about 20% by weight, preferably about 0.01 to about 15% by weight, and more preferably about 0.01 to about 10% by weight of the slurry. The remainder of the slurry may comprise water, solvents and other additives as set forth herein. The pH of the slurry may range from 1 to 11.5, and preferably 2 to 11. The removal rate of the polishing process varies depending on the material being polished but is generally greater than 100 nm/min, preferably greater than 200 nm/min, and more preferably greater than 250 nm/min for harder materials (e.g., hard disk, glass, etc.) For softer materials (e.g., copper, and other metals) the removal rate is generally greater than 400 nm/min, preferably greater than 600 nm/min. The surface roughness (Ra) for materials polished is generally less than 0.75 nm, preferably less than 0.69 nm, and more preferably less than 0.65 nm; and the maximum peak valley difference (P/V) is generally less than 6.49 nm, preferably less than 5.99 nm, and more preferably less than 5.50 nm.

In another embodiment of the present invention, a CMP slurry comprises a dispersing medium, polydisperse abrasive particles, and oxidizing agent; wherein the slurry comprising an abrasive solids content of 5% by weight of the slurry and a pH of about 2.3 removes nickel phosphide from a nickel phosphide substrate at a rate of at least 155 nm/min using a Labopol-5 polisher with a Rodel DPC 6350 pad having 30 Newton down force at 150 rpm rotation rate. The CMP process and slurry components are utilized as set forth in Example 1. Preferably, the removal rate is at least about 200 nm/min with a surface roughness (Ra) of less than about 0.69 nm and a peak valley difference (PN) of less than about 6.6 nm, and more preferably, the removal rate is at least about 225 nm/min with a surface roughness (Ra) of less than about 0.65 nm and a peak valley difference (PN) of less than about 6.5 nm.

In another embodiment of the present invention, a CMP slurry comprises a dispersing medium, polydisperse abrasive particles, and oxidizing agent; wherein the slurry comprising an abrasive solids content of 5% by weight of the slurry and a pH of about 6.3 removes glass from a glass substrate at a rate of at least 155 nm/min using a Labopol-5 polisher with a Rodel DPC 6350 pad having 30 Newton down force at 150 rpm rotation rate. The CMP process and slurry components are utilized as set forth in Example 3. Preferably, the removal rate is at least about 200 nm/min with a surface roughness (Ra) of less than about 0.55 nm and a peak valley difference (P/V) of-less than about 14.5 nm, and more preferably, the removal rate is at least about 225 nm/min with a surface roughness (Ra) of less than about 0.50 nm and a peak valley difference (P/V) of less than about 14.0 nm.

The entire subject matter of all patents and publications listed in the present application are incorporated herein by reference.

The following Examples are given as specific illustrations of the claimed invention. It should be understood, however, that the invention is not limited to the specific details set forth in the Examples. All parts and percentages in the Examples, as well as in the remainder of the specification, are by weight unless otherwise specified.

Furthermore, any range of numbers recited in the specification or claims, such as that representing a particular set of properties, conditions, physical states or percentages, is intended to literally incorporate expressly herein any number flowing within such range, including any subset of numbers with any range so recited. Any modifications of the invention, in addition to those shown and described herein, will become apparent to those skilled in the art from the foregoing description and accompanying drawings. Such modifications are intended to fall within the scope of the appended claims.

### Example 1

### Comparative Polishing of NIP (Hard Disk Polishing)

In this comparison the polishing rate and post-polish surface smoothness are determined for the abrasive particles (set forth in Table I) suspended in an aqueous solution containing H₂O₂ (2% by mass, total slurry basis) and lactic acid (2% by mass, total slurry basis). The pH of all suspensions is 2.3 ±0.1. The polishing is done using a Labopol-5 polisher available from Struers A/S with 30 Newton down force, 150 rpm rotation rate and a 60 ml/min slurry flow rate (onto the polisher). The pad used was a Rodel DPC 6350. The substrate used for polishing is NIP on aluminum. The substrates are 9.5 cm disks purchased from Komag (San Jose, CA) and have a 12-15 micron NiP layer over aluminum. The elemental composition was approximately 85% nickel and 15% phosphorous. After polishing, the substrate is rinsed and dried. Polishing rate (removal rate) is determined by weight loss. The surface smoothness is characterized using a Horizon non-contact optical profilometer available from Burleigh Instruments, Inc. The values of Ra (average surface roughness) and PN (maximum peak valley difference) are the surface smoothness parameters used for comparison. The Ra value reflects general surface smoothness (lower value is smoother) while the PN (Peak/Valley) value is particularly sensitive to surface scratches.

In this evaluation a polishing slurry containing polydisperse colloidal silica is compared to otherwise identical slurries containing monodisperse colloidal silica, precipitated silica, and fumed silica and colloidal alumina. A summary of polishing results is given in the following table:

**Table I**

| **Comparison of Abrasives in Lactic Acid/H₂O₂ Slurry for NiP Polishing** | | | | | | | |
|---|---|---|---|---|---|---|---|
| Abrasive Particle | Conc. | Size (by Volume) | | | Removal Rate | Ra | P/V |
| | | Med. nm | %>100nm Span nm | | (nm/min) | (nm) | (nm) |
| Polydisperse Colloidal | 5% | 49.5 | 40 | 0 | 286 | .38 | 4.02 |
| Monodisperse Colloidal | 5% | 22 | <10 | 0 | 154 | .69 | 6.64 |
| Fumed Silica | 5% | 130 | unk. | unk. | 144 | .87 | 9.43 |
| Precip. Silica | 5% | 100 | unk. | unk. | 107 | .70 | 7.03 |

Results clearly show that the polydisperse colloidal silica provides the greatest removal rate while providing a polished surface quality that is superior (smoother) than that achieved with the other three abrasives.

### Example 2

### Comparative Polishing of NIP

Conditions for this comparison are essentially equivalent to those in Example 1 except that 1% Fe(NO₃)₃ is used in place of 2%H₂O₂ and the lactic acid concentration is reduced to 1.5%. The pH of all suspensions are 2.0 ± .1. In this evaluation a polishing slurry containing polydisperse colloidal silica is compared to otherwise identical slurries containing monodisperse colloidal silica, fumed silica, and precipitated silica. A summary of polishing results is given in the following table:

**Table II**

| **Comparison of Abrasives in Lactic Acid/Fe(NO₃)₃ Slurry for NiP Polishing** | | | | | | | |
|---|---|---|---|---|---|---|---|
| Abrasive Particle | Conc. | Size (by Volume) | | | Removal Rate | Ra | P/V |
| | | Med. nm | Span %>100nm nm | | (nm/min) | (nm) | (nm) |
| Polydisperse Colloidal | 5% | 49.5 | 40 | 0 | 305 | .49 | 3.93 |
| Monodisperse Colloidal | 5% | 22 | <10 | 0 | 188 | .75 | 5.99 |
| Fumed Silica | 5% | 130 | unk. | >50 | 144 | .98 | 10.23 |
| Precip. Silica | 5% | 100 | unk. | 50 | 97 | .74 | 7.56 |

Again, the slurry with the polydisperse colloidal silica (having a very low fraction of particles greater than 100nm) shows greatest removal rate and best surface quality (smoothness with least scratching).

### Example 3

### Comparative Polishing of Glass

In this comparison identical polishing conditions were employed to compare the same abrasives for glass polishing. The 9.5 cm glass disks were essentially pure silica glass with an initial surface roughness (Ra value) of 2-1.0 nm. The particles were suspended in a 0.2% aqueous solution of polyacrylic acid resulting in a pH of 6.3 ±.1.

**Table III**

| **Comparison of Abrasives in Polyacrylic Acid Slurry for Glass Disk Polishing** | | | | | | | |
|---|---|---|---|---|---|---|---|
| Abrasive Particle | Conc. | Size (by volume) | | | Removal Rate | Ra | P/V |
| | | Med. nm | Span %>100nm nm | | (nm/min) | (nm) | (n/m) |
| Polydisperse Colloidal | 5% | 49.5 | 40 | 0 | 243 | .54 | 10.3 |
| Monodisperse Colloidal | 5% | 22 | <10 | 0 | 139 | .53 | 14.7 |
| Fumed Silica | 5% | 130 | unk. | >50 | 113 | .89 | 19.4 |
| Precip. Silica | 5% | 100 | unk. | 50 | 159 | .76 | 12.5 |

Again, the polydisperse colloidal silica gave the highest removal rate, least scratching, and surface roughness only equaled by the monodisperse colloidal silica.

### Example 4

### Polishing of Copper in Damascene Process

In the copper damascene process (1) trenches are etched into a dielectric layer, (2) a barrier layer is deposited thinly lining the trench and thinly covering the inter-trench dielectric, (3) copper is deposited at a thickness to fill the trench while also coating the inter-trench regions, and (4) a CMP process is used to polish away the copper in the inter-trench regions while leaving as much copper as possible within the trench. It is desirable to quickly polish away the excess copper while generating minimal dishing at the surface of the copper filling the trenches and minimal erosion of the dielectric between trenches.

Cu CMP slurries are prepared using identical solution phases (Amino acid, hydrogen peroxide as an oxidizer, and NH₄OH in water). In these solutions approximately 0.010% of particles are suspended. Polishing experiments are run to determine the Cu removal rate as well as the tendency of the slurry to promote dishing and erosion. The slope of the topography build-up relative to the copper removed is termed the dishing or erosion "susceptibility" for the structure of interest and may be used as a performance metric. This susceptibility value is dimensionless. The lower the value of slope, the lower the amount of topography at any given amount of copper removed and the better the performance. Both dishing and erosion susceptibilities are determined by a least squares fit method.

**Table IV**

| **Comparison of Abrasives in Amino acid/Oxidizer Slurry for Cu Polishing** | | | | | | | |
|---|---|---|---|---|---|---|---|
| Abrasive Particle | Conc. | Size (by volume) | | | Removal Rate | Dishing Suscept. | Erosion Suscept. |
| | ppmw. | Med. nm | Span %>100nm nm | | (nm/min) | | |
| Polydisperse Colloidal | 1000 | 49.5 | 40 | 0 | 619 | .153 | .023 |
| Monodisperse Colloidal | 35 | 22 | <10 | 0 | 430 | .159 | .054 |
| Monodisperse Colloidal | 35 | 65 | <10 | 0 | 434 | .152 | .035 |

The polydisperse colloidal silica slurry provides the best resistance to erosion (i.e., significantly lower erosion susceptibility) and essentially equal resistance to dishing even though the abrasive amount utilized in the slurry is significantly higher, which allows for a much higher removal rate.

## Claims

1. An abrasive composition for polishing substrates comprising:
a plurality of colloidal silica abrasive particles comprising a polydisperse particle size distribution with median particle size, by volume, being 20 nanometers to 100 nanometers, a span value, by volume, being greater than or equal to about 20 nanometers, the span value range is measured by subtracting the d₁₀ particle size from the d₉₀ particle size generated using transmission electron micrographs, wherein a fraction of said particles greater than 100 nanometers is less than or equal to 20% by volume of the abrasive particles.

2. An abrasive composition according to claim 1, wherein said abrasive particles comprise a polydisperse particle size distribution with median particle size, by volume, being 20 nanometers to 100 nanometers, a span value, by volume, being greater than or equal to 15 nanometers, wherein a fraction of said particles greater than 100 nanometers is less than or equal to 15% by volume of the abrasive particles.

3. An abrasive composition according to claim 1, wherein said abrasive particles comprise a polydisperse particle size distribution with median particle size, by volume, being 20 nanometers to 100 nanometers, a span value, by volume, being greater than or equal to 15 nanometers, wherein a fraction of said particles greater than 100 nanometers is less than or equal to 10% by volume of the abrasive particles.

4. An abrasive composition according to claim 1, wherein said abrasive particles comprise a polydisperse particle size distribution with median particle size, by volume, being 20 nanometers to 100 nanometers, a span value, by volume, being greater than or equal to 15 nanometers, wherein a fraction of said particles greater than 100 nanometers is less than or equal to 5% by volume of the abrasive particles.

5. An abrasive composition according to claim 1, wherein said abrasive particles comprise a polydisperse particle size distribution with median particle size, by volume, being 20 nanometers to 100 nanometers, a span value, by volume, being greater than or equal to 18 nanometers, wherein a fraction of said particles greater than 100 nanometers is less than or equal to 20% by volume of the abrasive particles.

6. An abrasive composition according to claim 1, wherein said abrasive particles comprise a polydisperse particle size distribution with median particle size, by volume, being 20 nanometers to 100 nanometers, a span value, by volume, being greater than or equal to 20 nanometers, wherein a fraction of said particles greater than 100 nanometers is less than or equal to 2% by volume of the abrasive particles.

7. An abrasive composition according to claim 1, wherein said abrasive particles comprise a polydisperse particle size distribution with median particle size, by volume, being 20 nanometers to 100 nanometers, a span value, by volume, being greater than or equal to 15 nanometers, wherein a fraction of said particles greater than 100 nanometers is less than or equal to 20% by volume of the abrasive particles.

8. An abrasive slurry composition for polishing substrates comprising:
a plurality of colloidal silica abrasive particles comprising a polydisperse particle size distribution with median particle size, by volume, being 20 nanometers to 100 nanometers, and a span value, by volume, being greater
than or equal to 20 nanometers, the span value range is measured by subtracting the d₁₀ particle size from the d₉₀ particle size generated using transmission electron micrographs, wherein a fraction of said particles greater than 100 nanometers is less than or equal to 20% by volume of the abrasive particles; and
a solution having one or more chemical reactants.

9. An abrasive slurry according to claim 8, wherein said abrasive particles comprise a polydisperse particle size distribution with median particle size, by volume, being 20 nanometers to 100 nanometers, a span value, by volume, being greater than or equal to 15 nanometers, wherein a fraction of said particles greater than 100 nanometers is less than or equal to 10% by volume of the abrasive particles.

10. An abrasive slurry composition according to claim 8, wherein said abrasive particles comprise a polydisperse particle size distribution with median particle size, by volume, being 20 nanometers to 100 nanometers, a span value, by volume, being greater than or equal to 18 nanometers, wherein a fraction of said particles greater than 100 nanometers is less than or equal to 20% by volume of the abrasive particles.

11. An abrasive slurry according to claim 8, wherein said abrasive particles comprise a polydisperse particle size distribution with median particle size, by volume, being 20 nanometers to 100 nanometers, a span value, by volume, being greater than or equal to 15 nanometers, wherein a fraction of said particles greater than 100 nanometers is less than or equal to 20% by volume of the abrasive particles.

12. A method for polishing substrates with an abrasive composition comprising:
providing a substrate to be polished; and
polishing the substrate using a plurality of colloidal silica abrasive particles comprising a polydisperse particle size distribution with median particle size, by volume, being 20 nanometers to 100 nanometers, a span value, by volume, being greater than or equal to 20 nanometers, the span value range is measured by subtracting the d₁₀ particle size from the d₉₀ particle size generated using transmission electron micrographs,
and wherein a fraction of said particles greater than 100 nanometers is less than or equal to 20% by volume of the abrasive particles.

13. A method according to claim 12, wherein said abrasive particles comprise a polydisperse particle size distribution with median particle size, by volume, being 20 nanometers to 100 nanometers, a span value, by volume, being greater than or equal to 15 nanometers, wherein a fraction of said particles greater than 100 nanometers is less than or equal to 10% by volume of the abrasive particles.

14. A method according to claim 12, wherein said abrasive particles comprise a polydisperse particle size distribution with median particle size, by volume being 20 nanometers to 100 nanometers, a span value, by volume, being greater than or equal to 18 nanometers, wherein a fraction of said particles greater than 100 nanometers is less than or equal to 20% by volume of the abrasive particles.

15. A method according to claim 12, wherein said abrasive particles comprise a polydisperse particle size distribution with median particle size, by volume being 20 nanometers to 100 nanometers, a span value, by volume, being greater than or equal to 15 nanometers, wherein a fraction of said particles greater than 100 nanometers is less than or equal to 20% by volume of the abrasive particles.

## Patentansprüche

1. Abrasive Zusammensetzung zum Polieren von Substraten, die eine Vielzahl von abrasiven, kolloidalen Siliciumdioxidteilchen umfasst, die eine polydisperse Teilchengrößenverteilung mit einer auf das Volumen bezogenen medianen Teilchengröße von 20 nm bis 100 nm und einem auf das Volumen bezogenen Spannwert größer als oder gleich etwa 20 nm aufweisen, wobei der Spannwertbereich durch Subtrahieren der d₁₀ Teilchengröße von der d₉₀ Teilchengröße gemessen wird, die unter Verwendung von Transmissionselektronenmikrobildern generiert wurden, wobei eine Fraktion der Teilchen, die größer als 100 nm sind, kleiner als oder gleich 20 Vol.-% der abrasiven Teilchen ist.

2. Abrasive Zusammensetzung nach Anspruch 1, bei der die abrasiven Teilchen eine polydisperse Teilchengrößenverteilung mit einer auf das Volumen bezogenen medianen Teilchengröße von 20 nm bis 100 nm und einem auf das Volumen bezogenen Spannwert größer als oder gleich 15 nm aufweisen, wobei eine Fraktion der Teilchengröße, die größer als 100 nm sind, kleiner als oder gleich 15 Vol.-% der abrasiven Teilchen ist.

3. Abrasive Zusammensetzung nach Anspruch 1, bei der die abrasiven Teilchen eine polydisperse Teilchengrößenverteilung mit einer auf das Volumen bezogenen medianen Teilchengröße von 20 bis 100 nm und einem auf das Volumen bezogenen Spannwert größer als oder gleich 15 nm aufweisen, wobei eine Fraktion der Teilchen, größer als 100 nm sind, kleiner als oder gleich 10 Vol.-% der abrasiven Teilchen ist.

4. Abrasive Zusammensetzung nach Anspruch 1, bei der die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder gleich 15 nm aufweisen, wobei eine Fraktion der Teilchen, die größer als 100 nm sind, kleiner als oder gleich 5 Vol.-% der abrasiven Teilchen ist.

5. Abrasive Zusammensetzung nach Anspruch 1, bei der die abrasiven Teilchen ein polydisperse Teilchengrößeverteilung mit einer auf das Volumen bezogenen medianen Teilchengröße von 20 nm bis 100 nm und einem auf das Volumen bezogenen Spannwert größer als oder gleich 18 nm aufweisen, wobei eine Fraktion der Teilchen, die größer als 100 nm. sind, kleiner als oder gleich 20 Vol.-% der abrasiven Teilchen ist.

6. Abrasive Zusammensetzung nach Anspruch 1, bei der die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder gleich 20 nm aufweisen, wobei eine Fraktion der Teilchen, die größer als 100 nm sind, kleiner als oder gleich 2 Vol.-% der abrasiven Teilchen ist.

7. Abrasive Zusammensetzung nach Anspruch 1, bei der die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder gleich 15 nm aufweisen, wobei eine Fraktion der Teilchen, die größer als 100 nm sind, kleiner als oder gleich 20 Vol.-% der Teilchen ist.

8. Abrasive Aufschlämmungszusammensetzung zum Polieren von Substraten, die
eine Vielzahl von abrasiven, kolloidalen Siliciumdioxidteilchen, die eine polydisperse Teilchengrößeverteilung mit einer auf das Volumen bezogenen medianen Teilchengröße von 20 nm bis 100 nm und einem auf das Volumen bezogenen Spannwert größer als oder gleich 20 nm aufweisen, wobei der Spannwertbereich durch Subtrahieren der d₁₀ Teilchengröße von der d₉₀ Teilchengröße gemessen wird, die unter Verwendung von Transmissionselektronenmikrobildern generiert werden, wobei eine Fraktion der Teilchen, die größer als 100 nm sind, kleiner als oder gleich 20 Vol.-% der abrasiven Teilchen ist, und
eine Lösung mit einem oder mehreren chemischen Reaktanten umfasst.

9. Abrasive Aufschlämmung nach Anspruch 8, bei der die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder gleich 15 nm aufweisen, wobei eine Fraktion der Teilchen, die größer als 100 nm sind, kleiner als oder gleich 10 Vol.-% der abrasiven Teilchen ist.

10. Abrasive Aufschlämmung nach Anspruch 8, bei der die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder 18 nm aufweisen, wobei eine Fraktion der Teilchen, die größer als 100 nm sind, kleiner als oder gleich 20 Vol.-% der abrasiven Teilchen ist.

11. Abrasive Aufschlämmung nach Anspruch 8, bei der die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder gleich 15 nm aufweisen, wobei eine Fraktion der Teilchen, die größer als 100 nm sind, kleiner als oder gleich 20 Vol.-% der abrasiven Teilchen ist.

12. Verfahren zum Polieren von Substraten mit einer abrasiven Zusammensetzung, bei dem
ein zu polierendes Substrat bereitgestellt wird, und
das Substrat unter Verwendung einer Vielzahl von abrasiven, kolloidalen Siliciumdioxidteilchen poliert wird, die eine polydisperse Teilchengrößeverteilung mit einer auf das Volumen bezogenen medianen Teilchengröße von 20 nm bis 100 nm und einem auf das Volumen bezogenen Spannwert größer als oder gleich 20 nm aufweist, wobei der Spannwertbereich durch Subtrahieren der d₁₀ Teilchengröße von der d₉₀ Teilchengröße gemessen wird, die unter Verwendung von Transmissionselektonenmikrobildern generiert wurden, und wobei eine Fraktion der Teilchen, die größer als 100 nm sind, kleiner als oder gleich 20 Vol.-% der abrasiven Teilchen ist.

13. Verfahren nach Anspruch 12, bei dem die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder gleich 15 nm aufweisen, wobei eine Fraktion der Teilchen, die größer als 100 nm sind, kleiner als oder gleich 10 Vol.-% der abrasiven Teilchen ist.

14. Verfahren nach Anspruch 12, bei dem die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als gleich 18 nm aufweisen, wobei eine Fraktion der Teilchen, die größer als 100 nm sind, kleiner als oder gleich 20 Vol.-% der abrasiven Teilchen ist.

15. Verfahren nach Anspruch 12, bei dem die abrasiven Teilchen eine polydisperse Teilchengrößeverteilung mit einer auf das Volumen bezogenen medianen Teilchengröße von 20 nm bis 100 nm und einem auf das Volumen bezogenen Spannwert größer als oder gleich 15 nm aufweisen, wobei eine Fraktion der Teilchen, die größer als 100 nm sind, kleiner als oder gleich 20 Vol.-% der Abrasivteilchen ist.

## Revendications

1. Une composition abrasive pour le polissage de substrats comprenant :
une pluralité de particules abrasives à base de silice colloïdale comprenant une distribution polydisperse des tailles de particules, dont la taille moyenne des particules, en volume, est de 20 nanomètres à 100 nanomètres, la valeur de l'intervalle de la distribution, en volume, étant supérieure ou égal à 20 nanomètres, la valeur de l'intervalle de la distribution étant déterminée par soustraction de la taille des particules d₁₀ de la taille des particules d₉₀ générées par micrographies électronique de transmission, composition dans laquelle la fraction des particules supérieures à 100 nanomètres est inférieure ou égale à 20% en volume des particules abrasives.

2. Une composition abrasive selon la revendication 1, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, composition dans laquelle la fraction desdites particules supérieure à 100 nanomètres est inférieure ou égale à 15% en volume des particules abrasives.

3. Une composition abrasive selon la revendication 1, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, composition dans laquelle la fraction desdites particules supérieure à 100 nanomètres est inférieure ou égale à 10% en volume des particules abrasives.

4. Une composition abrasive selon la revendication 1, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, composition dans laquelle la fraction desdites particules supérieure à 100 nanomètres est inférieure ou égale à 5% en volume des particules abrasives.

5. Une composition abrasive selon la revendication 1, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 18 nanomètres, composition dans laquelle la fraction desdites particules supérieure à 100 nanomètres est inférieure ou égale à 20% en volume des particules abrasives

6. Une composition abrasive selon la revendication 1, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 20 nanomètres, composition dans laquelle la fraction desdites particules supérieures à 100 nanomètres est inférieure ou égale à 2% en volume des particules abrasives.

7. Une composition abrasive selon la revendication 1, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, composition dans laquelle la fraction desdites particules supérieure à 100 nanomètres est inférieure ou égale à 20% en volume des particules abrasives.

8. Une composition de bouillie abrasive pour le polissage de substrats comprenant: une pluralité de particules abrasives à base de silice colloïdale comprenant une distribution polydisperse des tailles de particules, dont la taille moyenne des particules, en volume, est de 20 nanomètres à 100 nanomètres, dont la valeur de l'intervalle de la distribution, en volume, est supérieur ou égal à 20 nanomètres, la valeur de l'intervalle de la distribution étant déterminée par soustraction de la taille des particules d₁₀ de la taille des particules d₉₀ générées par micrographies électronique de transmission, composition dans laquelle la fraction des particules supérieures à 100 nanomètres est inférieure ou égale à 20% en volume des particules abrasives et comprenant un ou plusieurs réactifs chimiques..

9. Une composition de bouillie abrasive selon la revendication 8, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, composition dans laquelle la fraction desdites particules supérieure à 100 nanomètres est inférieure ou égale à 10% en volume des particules abrasives.

10. Une composition de bouillie abrasive selon la revendication 8, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 18 nanomètres, composition dans laquelle la fraction desdites particules supérieure à 100 nanomètres est inférieure ou égale à 20% en volume des particules abrasives.

11. Une composition de bouillie abrasive selon la revendication 8, dans laquelle lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, composition dans laquelle la fraction desdites particules supérieure à 100 nanomètres est inférieure ou égale à 20% en volume des particules abrasives.

12. Un procédé pour polir des substrats avec une composition abrasive comprenant :
- la mise à disposition d'un substrat à polir ; et
- le polissage du substrat à l'aide d'une pluralité de particules abrasives à base de silice colloïdale comprenant une distribution polydisperse des tailles de particules, dont la taille moyenne des particules, en volume, est de 20 nanomètres à 100 nanomètres, dont la valeur de l'intervalle de la distribution, en volume, est supérieure ou égal à 20 nanomètres, la valeur de l'intervalle de la distribution étant déterminée par soustraction de la taille des particules d₁₀ de la taille des particules d₉₀ générées par micrographies électronique de transmission, procédé dans lequel la fraction des particules supérieures à 100 nanomètres est inférieure ou égale à 20% en volume des particules abrasives.

13. Un procédé selon la revendication 12, dans lequel lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, procédé dans lequel la fraction desdites particules supérieure à 100 nanomètres est inférieure ou égale à 10% en volume des particules abrasives.

14. Un procédé selon la revendication 12, dans lequel lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 18 nanomètres, procédé dans lequel la fraction desdites particules supérieure à 100 nanomètres est inférieure ou égale à 20% en volume des particules abrasives.

15. Un procédé selon la revendication 12, dans lequel lesdites particules abrasives comprennent une distribution polydisperse des tailles de particules dont la taille moyenne des particules, en volume, est de 20 nanomètres à 100 nanomètres, la valeur de l'intervalle de la distribution, en volume, étant supérieure ou égal à 15 nanomètres, procédé dans lequel la fraction desdites particules supérieure à 100 nanomètres est inférieure ou égale à 20% en volume des particules abrasives.
